# EUROPEAN PATENT APPLICATION

(11) **EP 4 794 017 A1**
(43) Date of publication of application: **19.08.2026**
(21) Application number: 24877004.2
(22) Date of filing: 19.09.2024
(51) Int. Cl.: H01M 4/139, H01M 4/04, H01M 4/62, H01M 10/052, H01M 10/054

(54) **QUALITY CONTROL SYSTEM FOR SECONDARY BATTERY AND QUALITY CONTROL METHOD USING SAME**

(30) Priority: 10.10.2023 JP 2023174939
(71) Applicant: Hitachi High-Tech Corporation, Minato-ku Tokyo 105-6409 (JP)
(72) Inventor: KAWAJI, Jun, Tokyo 100-8280 (JP); KONISHI, Hiroaki, Tokyo 100-8280 (JP); SUZUKI, Chieko, Tokyo 100-8280 (JP); OOMINAMI, Yuusuke, Tokyo 105-6409 (JP); EBINE, Yuuta, Tokyo 105-6409 (JP); FURIKI, Masanari, Tokyo 105-6409 (JP)
(74) Representative: Mewburn Ellis LLP
(86) International application number: PCT/JP2024/033437
(87) International publication number: WO 2025/079405

(57) **Abstract**

In order to provide a secondary battery quality control system and a secondary battery quality control method that allow performance of a completed secondary battery to be predicted on the basis of structure information of an electrode mixture sheet produced during manufacturing steps, the following configuration is provided. There are provided the quality control system for a secondary battery includes: a storage unit that stores a performance prediction model obtained by formulating correlation between structure information of an electrode mixture sheet and performance information of the secondary battery manufactured by applying the electrode mixture sheet; and a performance prediction unit that inputs the structure information of the newly manufactured electrode mixture sheet to the performance prediction model to predict electrode performance of the secondary battery manufactured by applying the electrode mixture sheet, and the secondary battery quality control method.

## Description

### Technical Field

The present invention relates to a quality control system for a secondary battery, and to a quality control method using the same.

### Background Art

In order to reduce CO₂ emissions, there is a growing need to use fossil-fuel-free secondary batteries as driving forces for moving bodies or the like. In addition, in an electrical power system also, it is necessary to increase the proportion of renewable energy sources, such as solar power generation or wind power generation, as alternative power-supply energy sources to fossil fuels and, to provide adjusting power for suppressing output fluctuations, there is a growing need for an electric energy storage system using a secondary battery. Against the backdrop described above, there is a growing need to manufacture secondary batteries represented by a lithium ion secondary battery.

Challenges for the secondary batteries include improving energy efficiency related to manufacturing and improving resource efficiency. To achieve these, it is necessary to increase the yield of the manufactured batteries but, due to material variations within the batteries, quality defects of battery internal members due to conditions hard to control, and the like, it is difficult to improve the yield. Among the battery internal members, an electrode mixture sheet can be listed as one that significantly affects the yield.

In the secondary battery, the electrode mixture sheet contains an active material that stores charges, a conductive additive for conducting electrons to the active material, and a binding agent (binder) that binds these together, and it is considered that battery performance is affected by the presence or absence of a defect during manufacturing, an aggregate size, and a state of dispersion of the constituent materials. As a known technology for improving the yield, a method of inspecting the electrode mixture sheet after the manufacturing by using various approaches is disclosed.

Patent Literature 1 discloses a method of imaging an electrode mixture sheet after being pressed by using an infrared camera, performing high-resolution processing on the obtained infrared image, comparing the image after the high-resolution processing to a defective image acquired in advance, to detect a defective portion, and determining the presence or absence of a defect in a roll-shaped electrode mixture sheet having an active material layer formed on at least one surface of a current collector and a type of the defect.

Patent Literature 2 discloses a method that includes: a step of marking a predetermined position on each of electrode mixture sheets before being wound; and a step of detecting an amount of misalignment between markings applied to adjacent electrode sheets among the markings applied to the plurality of wound electrode mixture sheets, to thereby detect introduction of folds or wrinkles or the like.

Patent Literature 3 discloses irradiating a surface of a thin electrode mixture sheet wound into a roll shape with inspection light to image the light transmitted thereby, the light specularly reflected thereby, and the light scattered thereby, and analyzing the resulting imaging data by using an image processing unit to record, on a recording medium, a type (black speck defect, white speck defect, gloss defect, fiber bundle defect, resin starvation defect, or pinhole defect) of a defect present in the sheet, a position where the defect is present, and a size of the defect.

### Citation List

### Patent Literature

PTL 1: Japanese Unexamined Patent Application Publication No. 2016-143641
PTL 2: Japanese Unexamined Patent Application Publication No. 2015-133259
PTL 3: Japanese Unexamined Patent Application Publication No. 2010-272250

### Summary of Invention

### Technical Problem

However, in Patent Literature 1 to Patent Literature 3, the presence or absence of an obvious defect, such as an electrode defect, can be identified, but it is difficult to recognize poor mixing or uneven distributions of constituent materials in an electrode mixture sheet without such an obvious defect, which leads to a problem in that, under the influence thereof, performance defects during manufacturing and shipping or during battery operation cannot be detected in advance. Since the performance defects during manufacturing and shipping cannot be detected in advance, the yield during the manufacturing steps deteriorates and, in addition, batteries are manufactured by using defective electrodes, which results in wasted time and energy. In addition, since the performance defects during battery operation cannot be detected in advance, the operating rate of a device or system using the battery of concern decreases.

In general, when the performance of a battery after being produced is not as intended at a battery material and process design stage, to clarify the reason therefor, it is possible to observe the battery by using an electron microscope or the like, check for the presence or absence of the poor mixture or uneven distribution described above, and reflect the result thereof in the material and process design. However, since such observation takes time, such observation is conducted in most cases to provide offline evaluation by extracting the sample of concern after the manufacturing and evaluation, and has not been used for an inspection in the manufacturing steps. In addition, even when electrode structure information can be acquired by a sampling inspection of the produced electrode mixture sheet, since a method of extracting a structural factor that may affect electrode performance has not been established yet, and the correlation between the battery performance during inspection and a degradation characteristic during operation is unclear, a feedback to the manufacturing steps based on an inspection result is difficult.

As described above, in the secondary battery manufacturing steps based on the currently published information, an uneven distribution of electrode materials, a structure defect thereof, and insufficient voids therein, which may occur during the manufacturing of an electrode mixture sheet to be used as a positive electrode (used as an abbreviation of a positive-side electrode) or a negative electrode (used as an abbreviation of a negative-side electrode), are not sensed in the manufacturing steps, which results in problems of performance defects during shipping inspection and lower manufacturing efficiency. In addition, another problem also arises in that, even when the above information is acquired in an electrode inspection, since the correlation between the battery performance and the degradation characteristic is unclear, a feedback to electrode manufacturing steps is difficult, resulting in a problem of lower manufacturing efficiency.

An object of the present invention is to provide a secondary battery quality control system and a secondary battery quality control method that allow performance of a completed secondary battery to be predicted on the basis of structure information of an electrode mixture sheet produced during manufacturing steps.

### Solution to Problem

A configuration of the present invention for solving the above problems is as follows. A secondary battery quality control system and a secondary battery quality control method are provided. The quality control system for a secondary battery includes: a storage unit that stores a performance prediction model obtained by formulating correlation between structure information of an electrode mixture sheet and performance information of the secondary battery manufactured by applying the electrode mixture sheet; and a performance prediction unit that inputs the structure information of the newly manufactured electrode mixture sheet to the performance prediction model to predict electrode performance of the secondary battery manufactured by applying the electrode mixture sheet. The structure information is information related to a structure of the electrode mixture sheet that has been measured after the manufacturing of the electrode mixture sheet to be applied to at least one of a positive electrode and a negative electrode of the secondary battery, and includes at least one of the presence or absence of a defect or break in at least one of the positive electrode and negative electrode, a ratio between constituent materials in an in-plane direction or a thickness direction of the electrode mixture sheet, a size of an aggregate made of the constituent materials, a crack occurring inside an electrode active material particle, and a ratio of voids in which the constituent materials are not present. The performance information is information related to performance of the secondary battery manufactured by using the electrode mixture sheet, and includes at least one of capacities during initial charging and discharging, a charge-discharge efficiency as a capacity ratio during charging and discharging, a battery capacity when a charging or discharging current is varied, and an AC resistance and a DC resistance at a predetermined charging rate.

### Advantageous Effects of Invention

According to the present invention, it is possible to provide a secondary battery quality control system and a secondary battery quality control method that allow performance of a completed secondary battery to be predicted on the basis of structure information of an electrode mixture sheet produced during manufacturing steps.

Objects, configurations, and effects other than the above will be apparent from the description of the following embodiments.

### Brief Description of Drawings

Fig. 1 is a diagram schematically illustrating an example of a configuration of a battery to be inspected in the present invention in a planar direction.
Fig. 2 is a diagram schematically illustrating an example of a configuration of the battery to be inspected in the present invention in a cross-sectional direction.
Fig. 3 is a diagram schematically illustrating an example of a configuration of an electrode mixture sheet included in the battery to be inspected in the present invention in the cross-sectional direction.
Fig. 4 is a diagram schematically illustrating an example of manufacturing steps for the battery to be inspected in the present invention.
Fig. 5 is a diagram schematically illustrating an example of a process flow related to an inspection system in the present invention.
Fig. 6 is a diagram schematically illustrating the step of extracting a sample to be inspected from the electrode mixture sheet during manufacturing in the inspection step in the present invention.
Fig. 7 is a diagram schematically illustrating an example of a process flow related to the inspection system in the present invention.
Fig. 8 is a diagram schematically illustrating an example of a process flow of performance and degradation prediction model construction related to the inspection system in the present embodiment.
Fig. 9 is a diagram schematically illustrating relationships among battery internal state parameters, a battery voltage-capacity curve, and a battery resistance-capacity curve to be used to construct a performance and degradation prediction model related to the inspection system in the present invention.
Fig. 10 is a diagram schematically illustrating an example of the process flow of the performance and degradation prediction model construction related to the inspection system in the present invention.
Fig. 11 is a diagram illustrating, as an example of structure information according to an embodiment of the present invention, surface scanning electron microscopic images and a result of composition analysis using energy-dispersive X-ray spectroscopy.
Fig. 12 is a diagram illustrating, as an example of the structure information according to the embodiment of the present invention, scanning electron microscopic images from an electrode cross section and a composition distribution result using the energy-dispersive X-ray spectroscopy.
Fig. 13 is a diagram illustrating, as an example of the structure information according to the embodiment of the present invention, an image analysis flow for evaluating the distributions of constituent materials on the basis of the surface scanning electron microscopic images.
Fig. 14 is a diagram illustrating, as an example of the structure information according to the embodiment of the present invention, an example of a result of evaluating the distributions of the constituent materials on the basis of the surface scanning electron microscopic images.
Fig. 15 is a diagram illustrating, as an example of battery performance information according to the embodiment of the present invention, a discharge rate characteristic.
Fig. 16 is a diagram illustrating, as an example of the battery performance information according to the embodiment of the present invention, a result of measuring an AC impedance for evaluating an ionic conduction resistance inside the electrode.
Fig. 17 is a diagram illustrating, as an example of the battery performance information according to the embodiment of the present invention, a discharge capacity retention rate during charge-discharge cycles.

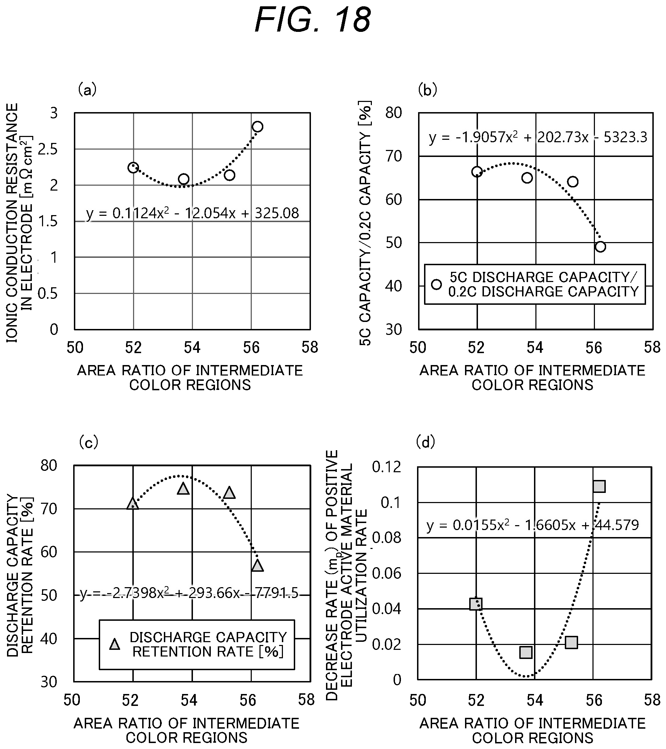

Fig. 18 is a diagram illustrating the correlation between an area ratio of intermediate color regions in a back scattered electron image, which is among structure information items according to the embodiment of the present invention, and battery performance ((a) Ionic conduction resistance inside the battery), (b) Ratio between a 5 C discharge capacity and 0.2 C discharge capacity in a discharge rate characteristic, (c) Discharge capacity retention rate in a charge-discharge cycle test, and (d) Rate of change in positive electrode active material utilization rate (mₚ) in the charge-discharge cycles). Description of Embodiments

Referring to the drawings, a mode (hereinafter referred to as the "embodiment") for carrying out the present invention will be described below as appropriate.

In describing an inspection system for battery manufacturing steps in the present invention, <Structure and Constituent Materials of Lithium Ion Battery> and <Manufacturing Steps for Lithium Ion Battery> will be described first, and then the inspection system in secondary battery manufacturing steps, which is the embodiment of the present invention, will be described. Note that the secondary battery targeted by the present invention is not limited to the lithium ion battery, and the lithium ion battery is merely shown as an example.

### <Structure and Constituent Materials of Lithium Ion Battery>

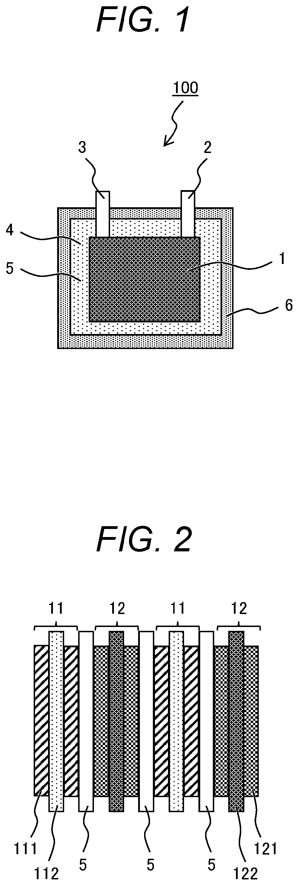

Using Fig. 1 and Fig. 2, a description will be given of a structure of a mode of the lithium ion battery. Fig. 1 is a diagram conceptually illustrating an example of a cross section of the lithium ion battery.

In Fig. 1, a cell (battery cell or secondary battery) 100 includes an electrode-occupied portion 1, a positive electrode terminal (tab) 2, a negative electrode terminal (tab) 3, an electrolytic solution 4, separators 5, and an outer casing 6. The outer casing 6 is configured of a laminate film or a material similar thereto. In Fig. 1, the plurality of separators and electrodes are laminated and sealed with the laminate film, but a laminated body wound and sealed into a cylindrical outer casing or sealed into a rectangular outer casing can also serve as an inspection target.

Fig. 2 is a diagram conceptually illustrating an example of a cross section of an energy storage element (constituent element of an energy storage mechanism) of the cell in Fig. 1. In Fig. 2, the energy storage element of the cell includes positive electrodes 11, negative electrodes 12, and the separators 5. Note that micro pores in the positive electrodes 11, the negative electrodes 12, the separators 5, and the like are impregnated with the electrolytic solution 4 as the battery. Therefore, the electrolytic solution 4 is not illustrated in Fig. 2.

In addition, in the energy storage element in Fig. 2, the positive electrodes 11 and the negative electrodes 12 are alternately arranged with the separators 5 being interposed therebetween. For the separators 5, e.g., polypropylene is used. However, in addition to polypropylene, a microporous film made of a polyolefin, such as polyethylene, nonwoven fabric, or the like can also be used for the separators 5. Note that Fig. 1 and Fig. 2 are diagrams conceptually illustrating an example of a cross section of the lithium ion battery and an example of a cross section of the energy storage element of the cell, and the positional relationship between the individual constituent members and sizes of the individual constituent members are not limited to those shown in the drawings.

Each of the positive electrodes 11 and the negative electrodes 12 is obtained by forming, on an metal current collector foil, an appropriate mixture of an electrode active material, a conductive agent, a binding agent, and the like into a sheet shape. In the present invention, such a sheet is referred to as the "electrode mixture sheet".

The lithium ion battery cell as one of the inspection targets in the present invention can use any current collector without being limited by a material, a shape, a manufacturing method, or the like.

### <Positive Electrodes 11>

As the current collector foil of each of the positive electrodes 11, any of an aluminum foil having a thickness of 10 to 100 µm, a perforated aluminum foil having a thickness of 10 to 100 µm and a hole diameter of 0.1 to 10 mm, expanded metal, a foam metal sheet, and the like is used. In addition, as the material described above, not only aluminum, but also stainless steel, titanium, or the like can also be used appropriately.

The electrode active material of the positive electrodes 11 preferably contains a reactive species in the inside thereof. The reactive species of the lithium ion battery is a lithium ion. In this case, the electrode active material contains a lithium-containing compound capable of reversely inserting and eliminating lithium ions. Examples of the type of the electrode active material of the positive electrodes 11 that can be listed include lithium transition metal phosphates such as lithium cobalt oxide, manganese-substituted lithium cobalt oxide, lithium manganate, lithium nickel oxide, and olivine-type lithium iron phosphate, and Li_{w}NiₓCo_{y}Mn_{z}O₂ (where each of w, x, y, z is zero or a positive value).

### <Negative Electrodes 12>

As the current collector foil of the negative electrodes 12, a copper foil having a thickness of 10 to 100 µm, a perforated copper foil having a thickness of 10 to 100 µm and a hole diameter of 0.1 to 10 mm, expanded metal, a foam metal sheet, or the like is used. As the material, in addition to copper, stainless steel, titanium, or the like can also be used as appropriate. The electrode active material of the negative electrodes 12 contains a material into or from which lithium ions can be reversibly inserted and eliminated. Examples of the usable type of the electrode active material of the negative electrodes 12 include natural graphite, a composite carbonaceous material obtained by forming a coating on natural graphite by a dry CVD method or a wet spraying method, artificial graphite produced through sintering by using a resin material such as epoxy or phenol or a pitch-based material obtained from petroleum or coal as a raw material, silicon (Si), graphite mixed with silicon, a non-graphitizable carbon material, lithium titanate Li₄Ti₅O₁₂, and the like.

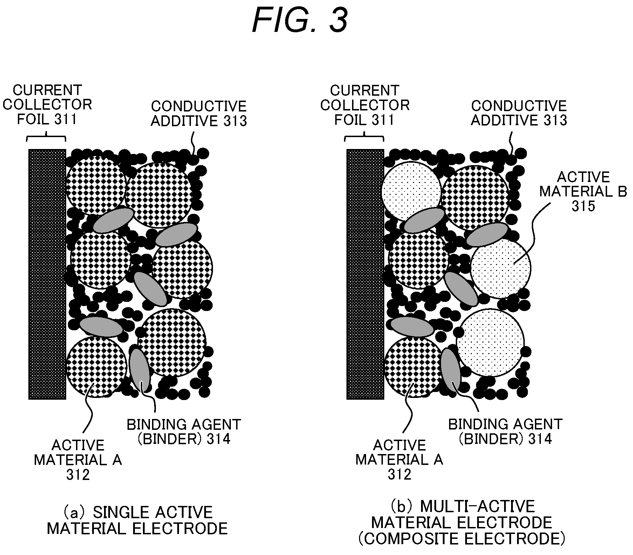

In addition, as the active materials of the positive electrodes and the negative electrodes described above, a plurality of materials can also be selected and applied as required. Fig. 3 is a diagram conceptually illustrating an electrode cross section in the lithium ion battery, in which (a) illustrates an electrode made of a single active material A 312 and (b) illustrates a composite electrode configured to include two active materials A 312 and B 315.

### <Electrolytic Solution>

The energy storage elements (constituent elements of the energy storage mechanism) include the electrolytic solution 4 in addition to the positive electrodes 11, the negative electrodes 12, and the separators 5. In the case of the lithium ion battery, examples of the electrolytic solution that can be used include aprotic organic solvents such as ethylene carbonate (EC), propylene carbonate (PC), butylene carbonate (BC), dimethyl carbonate (DMC), ethyl methyl carbonate (EMC), diethyl carbonate (DEC), methyl propyl carbonate (MPC), and ethyl propyl carbonate (EPC). In addition, an electrolytic solution in which a lithium salt such as lithium hexafluorophosphate, lithium tetrafluoroborate, lithium perchlorate, lithium iodide, lithium chloride, lithium bromide, LiB(OCOCF₃)₄, LiB(OCOCF₂CF₃)₄, LiPF₄(CF₃)₂, LiN(SO₂CF₃)₂, or LiN(SO₂CF₂CF₃)₂ is dissolved in a solvent of the two or more mixed organic compounds mentioned above can be listed. Moreover, an electrolyte solution in which the mixed lithium salts of two or more kinds mentioned above are dissolved can also be listed.

In general, the constituent solvents of the electrolytic solutions mentioned above are highly volatile, and volatilization temperatures of the electrolytic solutions are mostly less than 25 °C. In addition, in one of the embodiments of the present invention, it is also possible to use a lithium-ion-conducting liquid having a volatilization temperature increased to, e.g., 100 °C or more. Specifically, ionic liquids and solvated ionic liquids can be listed. Furthermore, it is also possible to use a solid electrolyte instead of an electrolytic solution.

### <Lithium Ion Battery Manufacturing Steps>

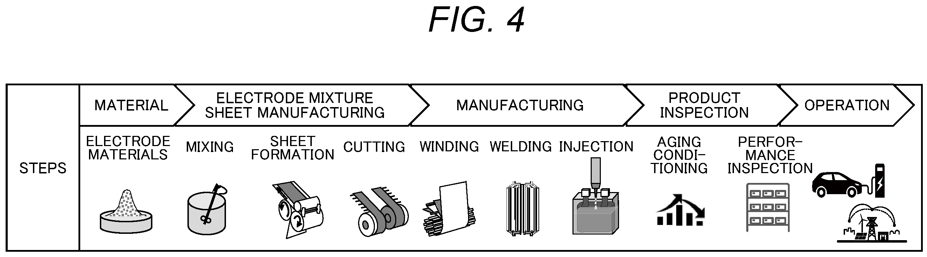

Fig. 4 schematically illustrates an example of manufacturing steps for the lithium ion battery. The electrode active materials, the conductive additive, and the binding agent (binder), which are the constituent materials, are mixed together, and then formed as the electrode mixture sheet. At this time, it is typical to form the sheet by applying a slurry formed by dispersing each of the materials in the solvent onto a current collector foil by using a blade coater, a die coater, or the like and drying the slurry. However, it is also possible to form the sheet by mixing together the solid active materials, the conductive additive, and the binding agent under pressure applied thereto with a roll or the like without dispersing each of the materials in the solvent, dispersing the mixture in that state over the current collector foil, and applying pressure thereto.

Alternatively, it is also possible to manufacture an electrode mixture sheet for a solid battery using a solid electrolyte instead of the electrolytic solution by additionally mixing the solid electrolyte in the materials mentioned above and forming the resulting mixture. Typically, the electrode mixture sheet formed on the current collector foil is cut into a predetermined size, laminated with the separators and the solid electrolyte, stored in a battery outer casing, immersed in an injected liquid, and sealed to provide a battery cell. In addition, by charging and discharging the battery after being manufactured under appropriate conditions and forming a stable coating between the electrode mixture sheet and the electrolyte, it is possible to allow the battery to maintain high performance during subsequent operation. This is referred to as conditioning or aging treatment.

Then, a performance test is performed before shipping, and the battery exhibiting predetermined performance is shipped as a normal product.

Examples of performance test items that can be listed include capacities during initial charging and discharging and a charge-discharge efficiency, which is a ratio therebetween, a battery capacity (rate characteristic) when a charging or discharging current is varied, an AC resistance and a DC resistance at a predetermined charging rate (SOC: State Of Charge), and the like.

When there is a cell having the test items falling below guaranteed performance, the cell is determined to be a defective product, discarded without being shipped, and disassembled, and the materials thereof are collected as necessary. In this step also, energy is consumed, and accordingly, in a manufacturing step at a high defect rate, deterioration of manufacturing efficiency, such as an amount of energy consumed per battery cell manufactured and cost thereof, presents a problem. When this defect determination cannot be made until the final step of a manufacturing line, energy related to manufacturing of defective products is also consumed, resulting in a lower efficiency.

### <Inspection Method in Manufacturing Steps>

As a solution to the problem of the deteriorated manufacturing efficiency described above, the present invention presents a method of extracting a specimen from a portion of the manufactured electrode mixture sheet, quantifying structure information as features in the subsequent structure inspection step, and using the features as control items for the acceptability determination of the electrode mixture sheet.

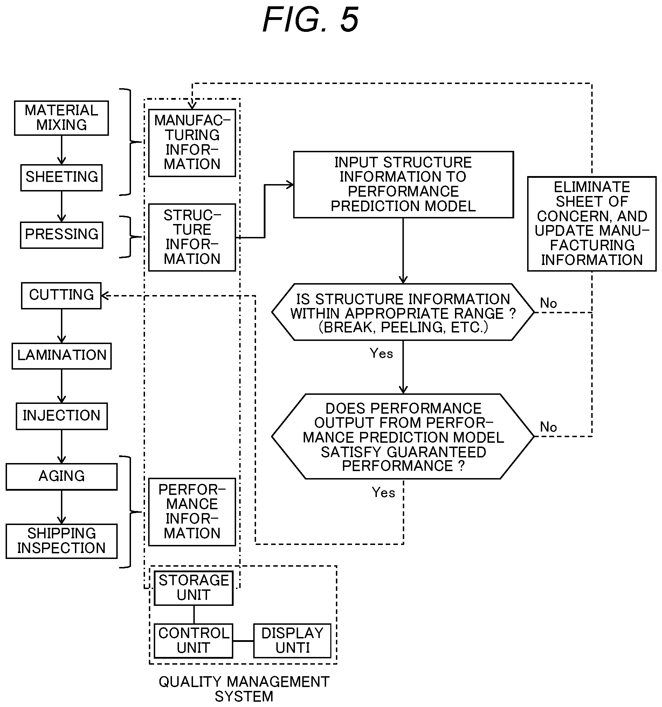

Fig. 5 shows an inspection method, which is one of the embodiments of the present invention, as a flow chart. In the present flow chart, manufacturing information, structure information, and performance information are acquired as three types of information items, and stores the acquired information items in a storage unit (referred to also as the "storage device") of an inspection system (referred to also as the "quality control system". The quality control system includes a control unit that performs various arithmetic processing, such as regression analysis, for the manufacturing information, the structure information, and the performance information that are stored in the storage unit, and a display unit that displays the results of arithmetic operations in the control unit. In addition, the quality control system includes the same components as those of a typical computer system, such as an input unit for inputting various data to the control unit, such as a keyboard, a printer for printing arithmetic results, and various interfaces that receive control signals from various devices related to the manufacturing of the electrode mixture sheet or the like.

The manufacturing information includes material specifications, manufacturing lots of the materials, mixing conditions, coating conditions (atmosphere, slurry viscosity, coating speed, and drying temperature), pressing conditions (pressure and pressurization time), and the like, each for forming the electrode mixture sheet.

As the structure information, in addition to the presence or absence of a defect or break in the electrode, a ratio among the constituent materials (active materials, conductive additive, and binder) in the in-plane and thickness directions of the electrode mixture sheet, sizes of aggregates made of the constituent materials, cracks occurring inside electrode active material particles, and a ratio of voids where the constituent materials are not present can be listed. In addition, three-dimensional information of these items, i.e., distributions of the items mentioned above in the sheet thickness direction can also be used as the structure information. As testing methods for acquiring the structure information described above, a scanning electron microscope (SEM), an optical microscope, a blackness measurement method, and the like can be listed. Moreover, information on element distributions in a sample using energy dispersive X-ray spectroscopy (EDX) attached to the scanning electron microscope can also be used appropriately as the structure information.

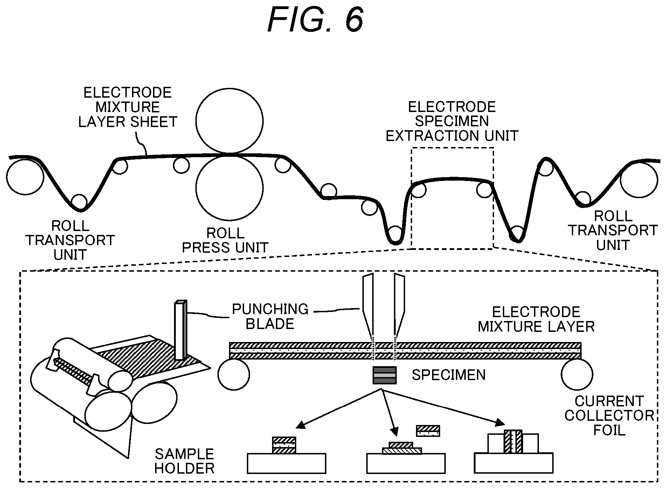

Since the testing is performed during the manufacturing steps, a specimen needs to be easily sampled and, as one of the embodiments of the present invention, a method of extracting a portion of a wound body made of the manufactured electrode mixture sheet by punching, and fixing the extracted portion to a holder for the inspection device mentioned above, as shown in Fig. 6, can also be listed. As the sample extraction method, another method of extracting the sample by machining using a laser can be listed, but the sample extraction method is not limited thereto.

By acquiring a SEM secondary electron image for a surface of the electrode mixture sheet fixed to the inspection holder and observing the morphology of the surface, it is possible to detect defects inside the electrode and quantify the degree thereof on the basis of the number and area ratio of defects per unit area. Likewise, the cracks inside the active material particles can also be detected on the basis of the secondary electron image and, by using a total sum of the number or lengths of the cracks inside the active material per unit area, the degree thereof can be quantified.

In addition, by using a SEM back scattered electron image, it is possible to obtain an observation image having a contrast reflecting the atomic weights of the constituent elements and, by quantifying the sizes of regions having different contrasts and the area ratio therebetween, it is possible to quantify aggregate sizes, the ratio among the constituent materials (active materials, conductive additive, and binder), and a void ratio. For the acquisition of the information in the thickness direction of the electrode mixture sheet, cross-section observation after the punching can be used, while it is also possible to peel the electrode mixture sheet extracted from the wound body from the current collector foil and acquire the surface information of the peeled surface close to the current collector foil by the method described above.

The performance information is acquired during the aging and shipping inspection of the manufactured cell, and includes the capacities during initial charging and discharging and the charge-discharge efficiency, which is the ratio therebetween, the battery capacity (rate characteristic) when the charging or discharging current is varied, the AC resistance and the DC resistance at the predetermined charging rate (SOC: State Of Charge), and the like that are described above.

In the inspection system in the present embodiment, the correlation between the acquired structure information and performance information is formulated to be used as a performance prediction model. The structure information of the newly manufactured electrode mixture sheet is input to the performance prediction model, and the battery performance when the electrode mixture sheet is applied is predicted in advance. At this time, when the predicted performance does not satisfy the guaranteed performance, by eliminating the electrode mixture sheet from the manufacturing steps, it is possible to prevent a battery defect from occurring at the subsequent stage. Specifically, as the structure information, it is determined whether or not there is a break or peeling inside the electrode, it is subsequently determined whether or not the performance output from the performance prediction model satisfies the guaranteed performance, and only the electrode mixture sheets that have each passed the determinations is cut, laminated, and formed into the electrode. The formulation of the correlation between the structure information and the performance information, the prediction of the battery performance using the formulated performance prediction model, the determination of whether or not the predicted performance satisfies the guaranteed performance, and the like, each described above, are executed in the "control unit" in the quality control system shown in Fig. 5. Of the "control unit", a portion (function) that predicts the battery performance may be referred to as the "performance prediction unit". It may also be possible that, when the control unit determines that the predicted performance does not satisfy the guaranteed performance, the determination result is displayed on the "display unit" in the quality control system.

Meanwhile, the electrode that did not satisfy the criterion in the determination is eliminated from the steps, while it is determined that the manufacturing conditions when the electrode mixture sheet was formed were not appropriate, and the manufacturing conditions can be updated. By repetitively performing the foregoing inspection and the updating of the manufacturing conditions, it is possible to reduce the risk of defects in the manufacturing steps and increase the manufacturing efficiency.

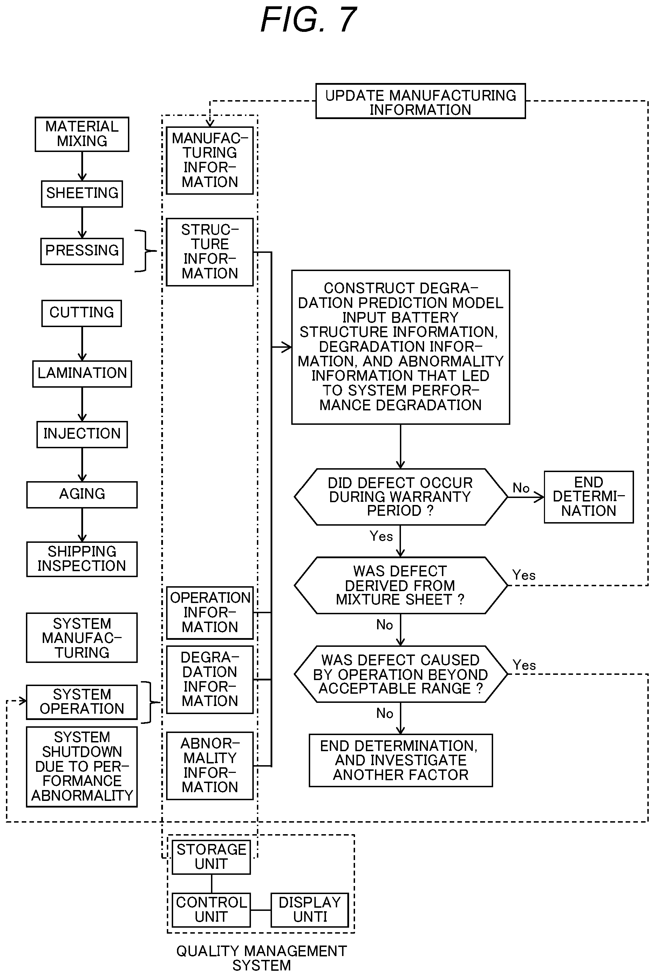

Fig. 7 illustrates an inspection system (referred to also as the "quality control system", which is one of the embodiments of the present invention, as a flow chart. Here, as the information to be used for the inspection, in addition to the manufacturing information and structure information shown in Fig. 5, operation information, the degradation information, and abnormality information are stored in a storage unit (referred to also as the "storage device"). The configuration of the quality control system is the same as that shown in Fig. 5, and therefore the description thereof is omitted. The operation information mentioned herein indicates a use history of the battery cell incorporated as a storage battery system after the shipping, and chronological data, such as a battery voltage, a current, and a temperature that are detected in a battery management system (BMS) for the storage battery system can mainly be used. Meanwhile, the degradation information means a battery performance change due to the operation described above. The degradation information can also be estimated by analyzing the BMS data.

In the storage battery system, when the battery is used under operation conditions adapted to battery specifications, the performance will degrade but, since the performance shifts according to the trend predicted in advance, the system can be used in a planned manner. However, when sudden degradation that deviates from the predicted trend occurs, it is determined that trouble has occurred in the system, and the operation thereof may be stopped. At this time, it is necessary to identify the reason for the abnormality and take corrective measures according to the reason. By comparing the degradation information obtained by inputting the structure information to the abnormality information in Fig. 7, it is possible to determine whether or not an abnormal factor occurred during the manufacturing of the battery and the electrode mixture sheet and whether the operation conditions are inappropriate.

### <Method of Formulating Correlation between Structure Information and Performance Information or Degradation Information>

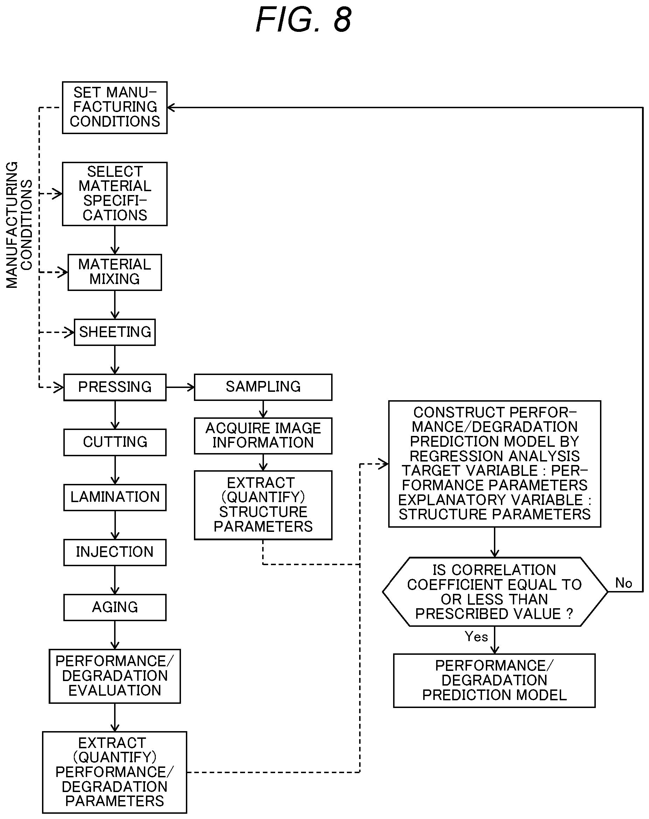

In Fig. 5 and Fig. 7, by formulating the correlation between the structure information and the performance information or the degradation information, it is possible to reduce a battery manufacturing defect rate and clarify the cause of the system trouble. The following will describe three examples of the formulation method. For the formulation, when materials and a process for determining the specifications of the battery to be manufactured are examined or when the manufacturing line is designed and subjected to trial operation, it is necessary to produce a plurality of electrode mixture sheets and acquire the structure information and the performance/degradation information for each of the electrode mixture sheets. The following will show the method of formulating the correlation using the acquired information, but the formulation of the correlation is not limited thereto. Meanwhile, the formulation of the correlation between the structure information and the degradation information and the implementation of the formulated degradation prediction model is performed by the control unit of the quality control system, similarly to the formulation and implementation of the performance prediction model. Of the "control unit", a portion (function) that performs the degradation prediction may be referred to as the "degradation prediction unit".
(i) At the material/process design stage for the target battery or during the trial operation of the manufacturing line, the manufacturing conditions are intentionally controlled to produce the electrode mixture sheets having different structures. For a group of electrodes for which only a specific manufacturing condition has been changed, the structure information is acquired from the electrode inspection, while the performance information is acquired from pre-shipping inspection of the manufactured batteries. Here, features (hereinafter referred to as structure parameters and performance parameters) indicating the structure information and the performance information are extracted and, by using the performance parameters or the deterioration parameters as target variables and using the structure parameters as target variables, the relationship therebetween is formulated by regression analysis, and stored in the storage device.
   The structure information of the electrode mixture sheet extracted from the manufacturing steps in Fig. 5 to Fig. 7 is input to the corresponding formula to predict the performance. Fig. 8 illustrates an example of a performance/degradation prediction model construction flow in the method described above. Determination of the manufacturing conditions for the electrode mixture sheet for acquiring information, production of the electrode and the battery based thereon, and acquisition of the corresponding structure parameters and performance/degradation parameters is repeated a plurality of times, and the prediction model is constructed by regression analysis. This process is repeated until the correlation coefficient thereof becomes equal to or less than a predetermined value to obtain the performance prediction model. A correlation formula to be obtained by the regression analysis is not particularly restricted, and a function clearly showing the correlation, such as a polynomial function, an exponential function, a logarithmic function, or a power function can appropriately be selected.
(ii) In the same manner as in (i), at the material/ process design stage for the target battery or during the trial operation of the manufacturing line, the manufacturing conditions are intentionally controlled to produce the electrodes having the different structures. At this time, the plurality of manufacturing conditions are varied to prepare a group of the electrode mixture sheets having the plurality of different structure parameters, and the performance parameters of batteries to which respective electrodes thereof are applied are evaluated. By performing multiple regression analysis on the obtained group of parameters, the performance parameters are represented by multi-dimensional functions of the structure parameters, which are stored in the storage device (referred to also as the "storage unit"). This step is the same as that in Fig. 8. However, since the types of the structure parameters to be handled increase, an amount of the information required for the formulation increases.
   To perform the formulation with a small amount of information, it is also possible to use machine learning.
(iii) Meanwhile, for the formulation, it is also possible to use a method using a battery model that reflects a phenomenon proceeding inside the battery. Specifically, it is possible to predict the performance information and the degradation information by reproducing a charge-discharge curve of the battery by using the battery internal state parameters related to the structure information. For the battery internal state parameters, a known technology, e.g., a method of estimating, from a shape change of a voltage-capacity curve or a resistance-capacity curve acquired during charging or discharging of the manufactured battery, the "battery internal state parameters" as a feature amount derived from an electrode internal material, which is described in Kohei Honkura, Ko Takahashi, and Tatsuo Horiba, Journal of Power Sources Vol. 196 Issue 23 (2011), Pages 10141-10147., can be used.

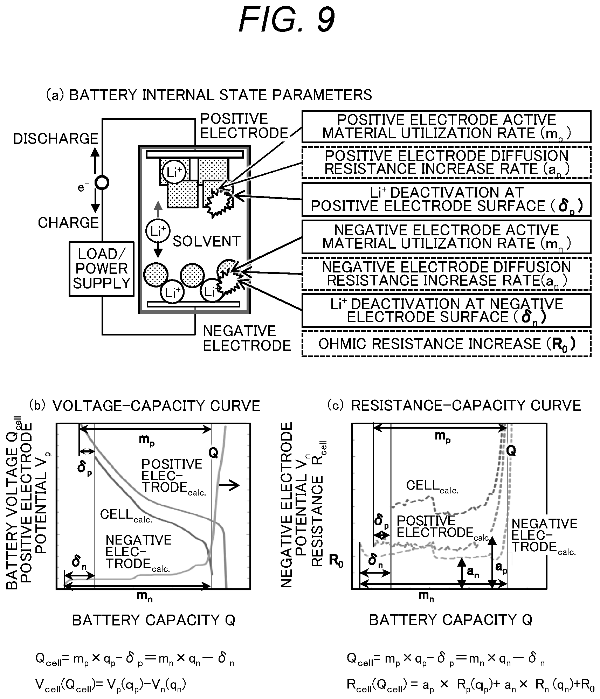

Fig. 9 illustrates an example of a reaction occurring inside the battery and the battery internal state parameters corresponding thereto.

The capacity dependency of the potential and the resistance of each of the electrodes (positive electrode and negative electrode) to be manufactured is intrinsic to the type of the active material used for the electrode unless there is a fatal structure abnormality, and the voltage-capacity curve of the battery can be represented as a potential-capacity curve difference between the positive electrode and the negative electrode. Meanwhile, the resistance-capacity curve of the battery can be represented as the total sum (ohmic resistance) of the resistance-capacity curve of each the electrodes and the electronic and ionic resistances of members.

When a structure abnormality occurs inside the electrodes or material degradation proceeds due to operation, capacity axes of the positive electrode and the negative electrode or lengths thereof in a resistance axis direction change or relative positions of the positive electrode and the negative electrode in a capacity axis direction change, to result in a battery performance change. In the above literature, the "battery internal state parameters" serving as an index of the state of the battery internal material can quantitatively be evaluated on the basis of the shape change of the voltage-capacity curve or the resistance-capacity curve of the batteries immediately after the manufacturing or during the operation.

Fig. 9(a) shows, as the battery internal state parameters, an active material utilization rate (mₚ) in the positive electrode, an active material utilization rate (mₙ) in the negative electrode, ion losses (δₚ and δₙ) on the surfaces of the positive electrode and the negative electrode, an ohmic resistance (R₀, electronic and ionic resistances of the constituent members) in each of the batteries, and ion diffusion resistance increase rates (aₚ and aₙ) inside the positive electrode and the negative electrode. As shown in Figs. 9(b) and 9(c), mₚ and mₙ affect enlargement/reduction of the curves of the positive electrode and the negative electrode in the voltage-capacity curves and the resistance-capacity curves in an abscissa axis direction. Meanwhile, δₚ and δₙ represent parallel movement distances (offset) of the respective curves in the capacity axis direction. In addition, Rₒ corresponds to the baseline of the battery resistance value in the resistance-capacity curve, while aₚ and aₙ represent scaling factors in an ordinate axis (resistance axis) direction of the resistance-capacity curves of the positive electrode and the negative electrode.

The structure information acquired with the SEM, the optical microscope, and the like is closely related to these battery internal state parameters. For example, of the structure information mentioned above, the ratio among the constituent materials (active materials, conductive additive, and binder) in a plane of the electrode mixture sheet affects mₚ, mₙ, and Rₒ. For example, in an electrode in which the binder agent is unevenly distributed in a large amount in a surface thereof, the electronic and ionic resistances at the surface tend to increase to result in increased Rₒ. Additionally, it is considered that the aggregate size affects Rₒ, aₚ, and aₙ, and cracks occurring inside the electrode active material particles affect aₚ and aₙ, while the void ratio affects Rₒ.

When the material degradation proceeds with the battery operation, each of the material parameters changes in a direction that causes degradation (mₚ and mₙ: decrease, δₚ, δₙ, aₚ, aₙ, and Rₒ: increase), and it is considered that the rate of change thereof is affected not only by operation conditions (chronological data of temperature, voltage, and current), but also by an initial structure defect. For example, in the positive electrode in which the binder agent is unevenly distributed in a large amount in a surface thereof, the binder agent is relatively insufficient on the current collector foil side and, accordingly, due to an electrode volume change during charging and discharging, peeling occurs, the utilization rate mₚ thereof, the resistance increase rate aₚ, and the ohmic resistance R₀ tend to change, and amounts of operation thereof, e.g., an operation time change, i.e., absolute values of dmₚ/dt, daₚ/dt, and dRₒ/dt tend to increase. The same applies also to the negative electrode.

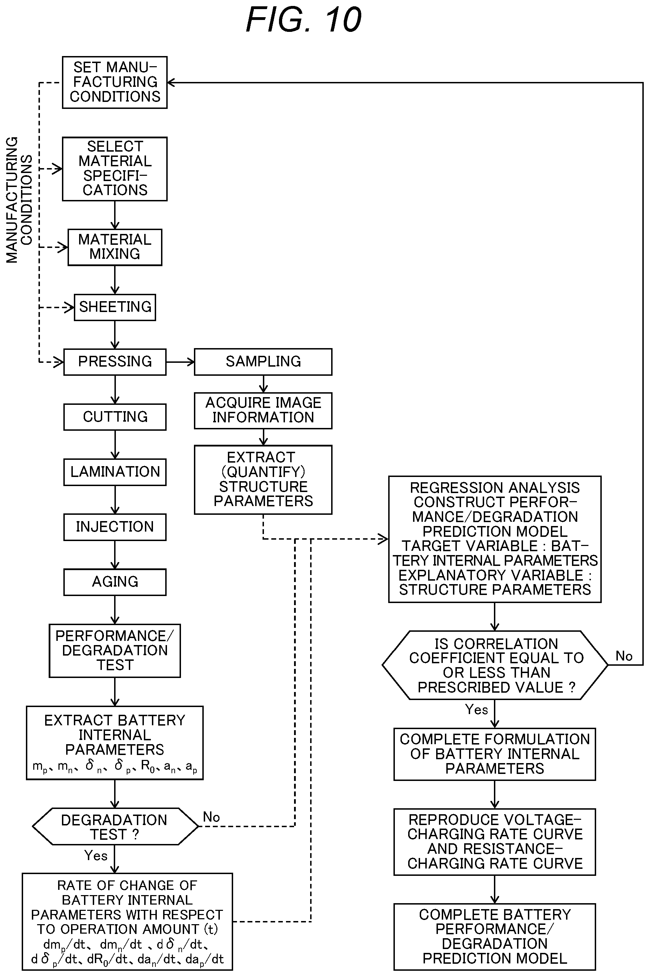

Fig. 10 schematically illustrates a flow of a preparatory inspection and regression analysis for constructing a performance/degradation prediction model by using battery internal information parameters. In order to obtain the correlation between the "structure information" and the "performance information" required in Fig. 5 by using the battery internal state parameters mentioned above, it is necessary to first prepare the electrode mixture sheets constructed under various manufacturing conditions in the preparatory inspection before the operation of the manufacturing line. Subsequently, the "structure parameters" extracted as numerical values from image information indicating the structures of the electrode mixture sheets and the "battery internal state parameters" extracted from the batteries using the electrodes thereof are acquired. Then, by acquiring the correlation therebetween by regression analysis, it is possible to predict the internal state parameters of a battery using electrodes having arbitrary structure parameters. Subsequently, by using the predicted internal state parameters and reproducing the voltage-capacity curve and resistance-capacity curve of the battery as shown in Figs. 9(b) and 9(c), it is possible to predict initial performance information (capacity, resistance, and input/output characteristics).

In addition, to derive the correlation between the "structure information" and the "degradation information", which is required in Fig. 7, the rate of change of each of the battery internal parameters with respect to the amounts of battery operation (operation time, a total amount of electricity charged and discharged, and a charge-discharge cycle count) is acquired in the preparatory inspection, and a relationship between the rate of change and the "structure parameters" is formulated by regression analysis. Subsequently, by inputting the structure parameters extracted from the electrode mixture sheets during the manufacturing and integrating the amounts of operation, it is possible to predict the battery internal parameters after a given period and, by reproducing the discharge curve by using the battery internal state parameters, it is possible to predict the battery performance after the given period.

Hereinbelow, embodiments for more specifically showing the inspection system (quality control system) in the manufacturing steps of the secondary battery according to the present invention will be introduced. The performance prediction model and the degradation prediction model that are used in the inspection system in the present invention are constructed by controlling the numerous manufacturing conditions and using the structure information and the performance information at that time but, in order to clearly describe the concept of the inspection system, simpler examples are used herein for the description.

### First Embodiment

### <Inspection System Focusing on Binder Distribution State in Positive Electrode Mixture Sheet>

An example is shown in which an object to be inspected was a positive electrode mixture sheet containing NCM (Li(Ni, Co, Mn) O₂) as the active material, a drying condition was varied as the manufacturing condition, and the correlation between the structure information and performance information thereof was examined. Table 1 shows an example of the positive electrode mixture sheets (Positive Electrode A to Positive Electrode D) applied to the construction of the performance prediction model and the degradation prediction model.

**[Table 1]**

| POSITIVE ELECTRODE | MANUFACTURING INFORMATION | STRUCTURE INFORMATION | PERFORMANCE INFORMATION | DEGRADATION INFORMATION | |
|---|---|---|---|---|---|
| | DRYING CONDITION | AREA RATIO OF INTERMEDIATE COLOR REGION [%] | 5 C DISCHARGE CAPACITY/0.2 C DISCHARGE CAPACITY [%] | DISCHARGE CAPACITY RETENTION RATE [%] | POSITIVE ELECTRODE ACTIVE MATERIAL UTILIZATION RATE [%] |
| A | 100°C | 52.0 | 66.4 | 71.3 | 93.1 |
| B | 120°C | 53.7 | 65.0 | 74.7 | 99.5 |
| C | 140°C | 55.3 | 64.1 | 73.8 | 99.0 |
| D | 160°C | 56.2 | 49.1 | 56.9 | 76.5 |

A slurry was produced by mixing NCM powder, which was an active material, acetylene black, which was a conductive additive, and PVdF, which was a binding agent at a weight ratio of 90:6.5:3.5, and adding N-methyl-2-pyrrolidone as a solvent to the resulting mixture. An Al foil having a thickness of 15 µm was coated with the produced slurry by using a comma coater, and dried for about 10 minutes in a drying oven. An amount of coating was 24 mg/cm² (per side) in terms of weight after the drying. A drying temperature was varied between 100 °C and 160 °C, as shown in Table 1.

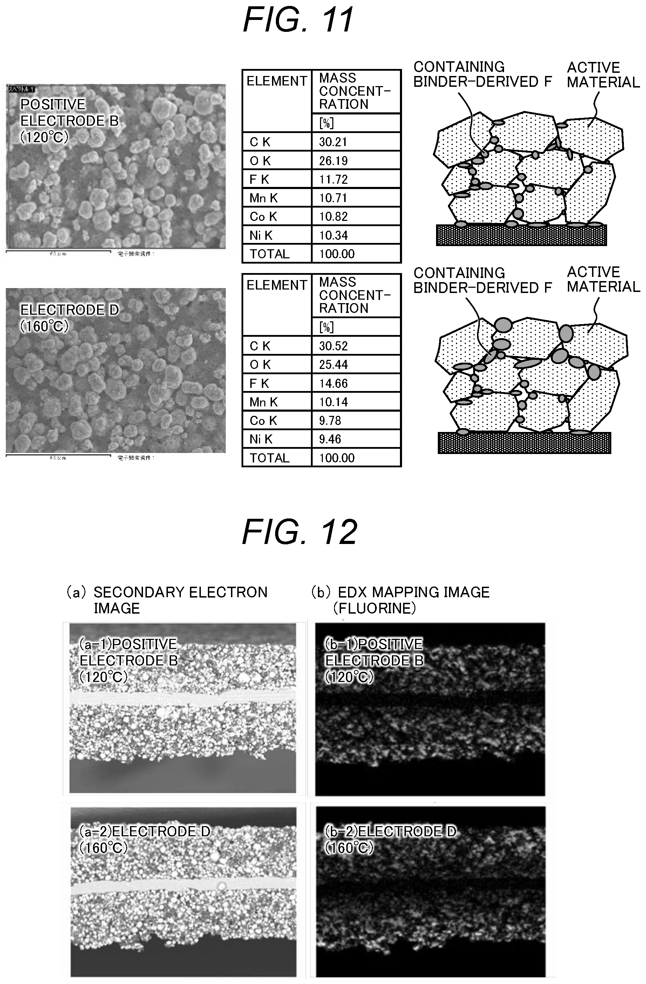

Fig. 11 shows a result of observing the morphology of the two types of positive electrode mixture sheets, which are the positive electrode B (dried at 120 °C) and the positive electrode D (dried at 160 °C), as viewed from the coated surfaces by using a scanning electron microscope (SEM), and evaluating element composition ratios in the surfaces by using EDX. In the positive electrode D, a large amount of fluorine resin derived from the binding agent was observed, which means that, when the solvent was rapidly dried from the current collector foil side to the electrode surface side under a high temperature condition as shown in the drawing, the fluorine resin dissolved in the solvent was unevenly distributed on the electrode surface, and precipitated. This phenomenon is referred to as binder migration.

As a method of acquiring agent non-uniformity within the electrode mixture sheets, which was caused by the binder migration, in addition to the SEM-EDX analysis from the sheet surface shown in Fig. 7, sheet cross-section observation and contrast analysis in surface SEM can be listed.

Fig. 12 shows a result of cross-section SEM observation, which is one of the embodiments of the inspection system in the present embodiment. The sheets in the drawing are the electrode B and the electrode D that are the same as those in Fig. 11. In the present measurement, in order to determine the acceptability of the sheets in the manufacturing steps in a short time, specimens were extracted by punching using a processing jig including a metal or ceramic blade, and observed without being subjected to cross-section polishing.

Of Fig. 12, (a) illustrates a secondary electron image, and (b) was obtained by mapping the abundance ratio of fluorine (F) derived from the binding agent, which was measured by EDX. It can be understood that, in the positive electrode D which was dried at a high temperature and in which the binder migration proceeded, fluorine elements were unevenly distributed, and concentrated in the sheet surface layer. The present information can also be stored as the structure information.

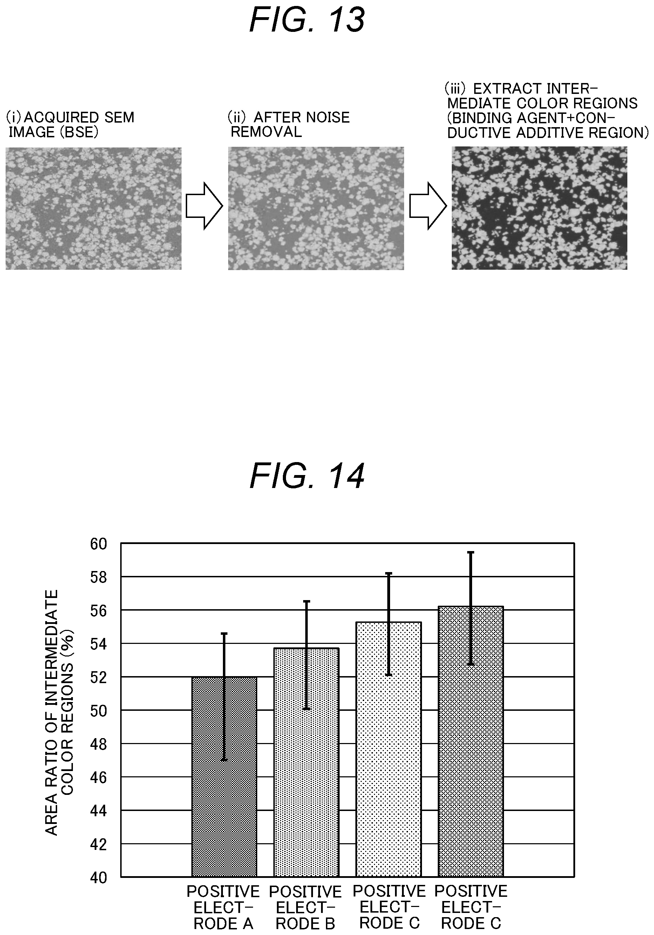

Fig. 13 schematically illustrates a method of quantifying and extracting the structure information from a surface SEM observation image, which is one of the embodiments of the inspection system in the present invention. (i) shows an observation image (back scattered electron image or BSE image) obtained by detecting back scattered electrons (BSE) from an observed object with respect to applied electrons in SEM. In the secondary electron image, as the atomic weight of the observed object is larger, brightness is higher and, in Fig. 13, the active material (NCM) regions have a higher contrast, while binding agent and conductive additive regions therearound appear lighter. Meanwhile, void regions where nothing exists appear dark. By utilizing this, in Fig. 13, noise in the image was removed in (ii), and then the active material regions, the binder agent and conductive additive regions, and the void regions were identified on the basis of the brightness of the contrast in (iii), and the constituent material composition in the sheet surface was quantified by using an area ratio thereamong.

Fig. 14 shows a result of quantifying the area ratio of the binding agent and conductive additive regions (intermediate color regions) in each of the positive electrode A to the positive electrode D in accordance with the above method. In the present measurement, in order to correct measurement variations depending on the measurement location, evaluation results in a plurality of observation regions of one sheet surface are shown. The heights of the bars in the graph of Fig. 14 represent average values, and variations thereof are evaluated by using error bars. The average value of the area ratios of the intermediate color regions is higher in the electrode which was dried at a higher temperature and in which the binding agent is more likely to be unevenly distributed in the surface thereof, and therefore it can be considered that the result in Fig. 14 was obtained by quantifying the uneven distribution of the binding agent as the structure information.

In another measurement method, highly adhesive conductive tapes were attached to the surfaces of the positive electrode A to the positive electrode D and, by using these, the current collector foils were peeled from the positive electrode A to the positive electrode D. As a result, electrode peeling was recognized in regions close to the current collector foils. Accordingly, on the peeled surfaces on the current collector foil side, the SEM observation was similarly performed, and the ratio of the intermediate color regions in the peeled surface was calculated by the same method as in Fig. 13. As a result, it was confirmed that the positive electrode D dried at a high temperature had the smallest intermediate color regions, and it was confirmed that, according to the present method also, it is possible to detect the uneven distribution of the binder in the electrode surface due to high-temperature drying.

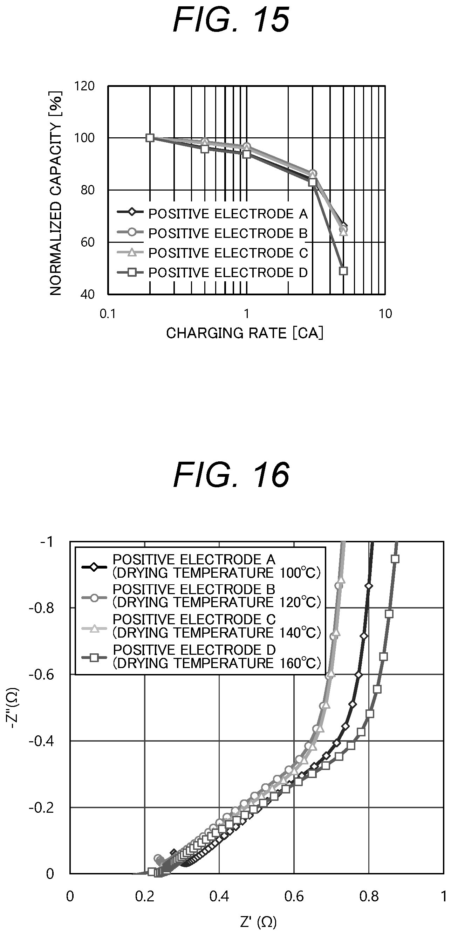

Fig. 15 illustrates a discharge rate characteristic, which is an item of the battery performance measured before shipping.

The abscissa axis represents a discharge rate, and xC means a current amount capable of charging or discharging an amount of electricity that can be stored in a battery in 1/x hours. It can be considered that, in Fig. 15, as the rate is higher (current value is higher), a discharge capacity decreases under the influence of the battery internal resistance, and this tendency is noticeable in the positive electrode A dried at a low temperature and in the positive electrode D dried at a high temperature. To quantitatively evaluate an effect exerted by a change in the electrode structure depending on the manufacturing conditions on an ionic conduction resistance inside the electrode, for each of the positive electrode A to the positive electrode D, a symmetric cell produced by holding the separator between the two same positive electrode sheets was prepared, and electrochemical impedance measurement (EIS) was performed at 25 °C.

The result thereof is shown in Fig. 16. The length of a region close to oblique 45° of each of the plots in the drawing corresponds to the magnitude of the ionic conduction resistance, and the ionic conduction resistance of each of the positive electrodes was evaluated therefrom. The result thereof is shown in Table 1. This indicates that, when the binder is unevenly distributed in the surface as in the positive electrode D, the binding agent in the uppermost surface of the electrode inhibits movement of electrons or ions into the active material to increase the resistance.

Meanwhile, it is expected that, in the positive electrode A which was dried at a low temperature and in which the amount of the binder in the surface is small, the uneven distribution of the binder in the vicinity of the current collector foil had relatively proceeded, and it can be considered that the ionic conduction resistance had consequently increased. Table 1 shows, as an example of the performance information, a ratio between a discharge capacity at 0.2 C (coulomb) and a discharge capacity at 5 C, which is in order of Positive Electrode B to Positive Electrode C>Positive Electrode A>Positive Electrode D, which is consistent with the order of the ionic conduction resistance (in ascending order of Positive Electrode B to Positive Electrode C<Positive Electrode A<Positive Electrode D).

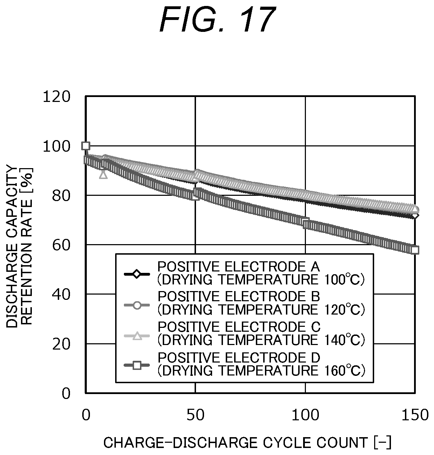

Fig. 17 illustrates a result of a charge/discharge cycle test imitating battery performance degradation during operation. The positive electrode A to the positive electrode D were combined with negative electrodes made of graphite and having the same specifications to produce laminate-type battery cells and, under a constant temperature environment at 25 °C, a charge-discharge cycle test was performed at a 1C (coulomb) rate.

The capacity decrease rate was higher in the battery cells using the positive electrodes A and D, compared to those in the cells using the positive electrodes B and C, and was particularly noticeable in the positive electrode D. As a result of acquiring the battery internal state parameters shown in Fig. 9 by comparing the voltage-capacity curve and resistance-capacity curve after degradation and before the degradation, a change of the positive electrode active material utilization rate mₚ differed from one positive electrode to another, which was 93.1% in the positive electrode A, 99.5% in the positive electrode B, 99.0% in the positive electrode C, and 76.5% in the positive electrode D. This order also seemed to be consistent with the order of the capacity decrease rates.

It was also found as a result of a battery disassembly test after the test that, in the positive electrode D in which the active material utilization rate had noticeably decreased, a deficit had occurred between the electrode mixture sheet and the Al current collector foil, bonding between the electrode mixture material and the current collector foil had deteriorated due to the uneven distribution of the binding agent to the surface layer, which is recognized in Fig. 11 to Fig. 14, the use of the positive electrode portion of the unbonded portion was impaired, and consequently the decrease of the active material utilization rate in the positive electrode is noticeable. Table 1 shows, as an example of the degradation information, a discharge capacity retention rate after 150 cycles in the cycle test, and it was found that, in the same manner as in Fig. 15 and Fig. 16, the discharge capacity retention rate was in order of Positive Electrode B to Positive Electrode C>Positive Electrode A>Positive Electrode D.

Fig. 18 was obtained by plotting the performance information (ionic conduction resistance in the electrode, and 5C Capacity/0.2C Capacity in a discharge rate test) and the degradation information (discharge capacity retention rate after 150 cycles, and Degradation Rate of Positive Electrode Active Material Utilization Rate: Decrease Rate of Positive Electrode Active Material Utilization Rate Mₚ Normalized per Cycle) that are shown in Table 1 with respect to the area ratio of the intermediate color regions, which is an item of the structure information. Additionally, in the drawing, a result of regression analysis (which is fitting with a quadratic function herein) when the performance information or the degradation information was used as the target variable, and the structure information was used as an explanatory variable. The present examination clarified that the area ratio of the intermediate color regions was extremely sensitive to any item of the performance information and degradation information.

This means that the ratio of the binder present in the surface obtained from the observation image at the positive electrode surface determines the initial performance and degradation characteristic of a battery to be manufactured later. It was shown that, by inspecting and controlling the structure information during the manufacturing, it was possible to identify an electrode mixture material layer that can guarantee battery performance. Specifically, by extracting a portion of the electrode mixture sheet continuously manufactured by a method as shown in Fig. 6, automatically performing steps of fixing the extracted portion to the inspection holder, transporting the inspection holder to a SEM device, adjusting an atmosphere, acquiring the back scattered electron image, and evaluating the area ratio of the intermediate color regions under conditions set in advance, and inputting the obtained area ratio to the performance prediction model and the degradation prediction model each constructed in advance, it is possible to predict the initial performance and the degraded performance during the operation when a battery cell is manufactured by using a wound body made of the electrode mixture sheet of concern.

When the prediction result is under an intended criterion (predetermined performance), the electrode can be determined to have a defect risk. When the electrode is determined to have a defect risk, a notification thereof can be made. The notification is preferably displayed on a monitor screen of a computer in the quality control system. A system operator can view the display on the monitor, and eliminate the battery having the defect risk from the line in advance. Alternatively, there may also be a mechanism that automatically eliminate the battery determined to have the defect risk from the line.

In addition, by formulating the correlation as shown in the graph of Fig. 18, it is possible to predict the performance or degradation parameters from the structure parameters obtained by quantifying the structure information, which also helps efficiently determine the manufacturing conditions when the battery manufacturing steps are started up. Furthermore, in the present examination, for the sake of simplicity, attention has been focused only on the area ratio of the intermediate color regions as the structure information. However, the void ratio, the sizes of the aggregates made of the plurality of active materials, and the like also vary depending on the drying temperature and, by performing multiple regression analysis by using these, the accuracy of prediction of performance and degradation characteristics for quality control is increased.

It should be noted that the present invention is not limited to the embodiments described above, and includes various modification examples.

For example, to clearly describe the present invention, the embodiment described above has shown the example of the positive electrodes in which the drying temperature included in the manufacturing information is deliberately varied in a wide range, and the drying speed significantly differs. However, in an actual manufacturing line, the drying temperature set in a device is mostly constant, but a drying situation varies depending on the lots of the active materials, a solvent mixture ratio, a slurry viscosity, a manufacturing line environment, or the like to cause a change in material distributions in the electrodes. In such a case also, it is possible to detect trouble in the electrode mixture sheet that causes performance defects by using the inspection method and procedure according to the first embodiment.

Meanwhile, in Fig. 18, the correlation among the structure information, the performance information, and the degradation information for the four positive electrode mixture sheets is plotted as a simple example. However, in reality, the correlation is found out from an information group for a large number of electrodes and formulated to be used for automatic acceptability determination. At this time, it is also possible to determine coefficients in a pre-set model expression, analyze the information group for the large number of electrodes by machine learning, and derive the correlation expression therefor.

As the structure information, not only the distributions of the constituent materials in the first embodiment, but also the aggregation size of the active material particles, the shape of each of voids formed between the materials, and the area ratio on the electrode surface can also be used appropriately. In addition, not only the distributions on the electrode surface, but also distributions in a thickness direction, a refractive index of the void, or the like can also be inspected and quantitatively evaluated by using a scanning electron microscope or an optical microscope, and can appropriately be used as the structure information. As a method of recognizing the distributions in the thickness direction, not only observation and analysis in a cross-sectional direction as in Fig. 12, but also observation and analysis in a surface direction of the electrode mixture sheet as in Fig. 13 can be used. In addition, by peeling the electrode mixture sheet from the current collector foil, observing and analyzing the peeled surface, and making a comparison therebetween, it is possible to evaluate uniformity in the thickness direction.

### Reference Signs List

100: cell (battery cell, secondary battery cell, secondary battery, lithium ion battery)
1: electrode-occupied portion
2: positive electrode terminal (tab)
3: negative electrode terminal (tab)
4: electrolytic solution
5: separator
6: outer casing
11: positive electrode
12: negative electrode
111: electrode mixture material layer of positive electrode
112: current collector foil of positive electrode
121: electrode mixture material layer of negative electrode
122: current collector foil of negative electrode
311: current collector foil
312: active material A
313: conductive additive
314: binding agent (binder)
315: active material B

## Claims

1. A quality control system for a secondary battery comprising:
a storage unit that stores a performance prediction model obtained by formulating correlation between structure information of an electrode mixture sheet and performance information of the secondary battery manufactured by applying the electrode mixture sheet; and
a performance prediction unit that inputs the structure information of the newly manufactured electrode mixture sheet to the performance prediction model to predict electrode performance of the secondary battery manufactured by applying the electrode mixture sheet,
wherein the structure information is information related to a structure of the electrode mixture sheet that has been measured after the manufacturing of the electrode mixture sheet to be applied to at least one of a positive electrode and a negative electrode of the secondary battery, and includes at least one of the presence or absence of a defect or break in at least one of the positive electrode and negative electrode, a ratio between constituent materials in an in-plane direction or a thickness direction of the electrode mixture sheet, a size of an aggregate made of the constituent materials, a crack occurring inside an electrode active material particle, and a ratio of voids in which the constituent materials are not present, and
wherein the performance information is information related to performance of the secondary battery manufactured by using the electrode mixture sheet, and includes at least one of capacities during initial charging and discharging, a charge-discharge efficiency as a capacity ratio during charging and discharging, a battery capacity when a charging or discharging current is varied, and an AC resistance and a DC resistance at a predetermined charging rate.

2. The quality control system for the secondary battery according to claim 1, further comprising:
a performance prediction model production unit that formulates the correlation between the structure information and the performance information to produce the performance prediction model,
wherein the storage unit stores the structure information and the performance information.

3. The quality control system for the secondary battery according to claim 1,
wherein the structure information is obtained by performing analysis by using at least one of a scanning electron microscope, an optical microscope, a blackness measurement method, and analysis of an element in a sample using X-ray spectroscopy attached to the scanning electron microscope.

4. The quality control system for the secondary battery according to claim 3,
wherein the structure information is obtained by extracting a portion of the manufactured electrode mixture sheet by punching or machining using a laser, fixing the extracted portion of the electrode mixture sheet to an inspection holder, and then performing analysis thereon by using at least one of the scanning electron microscope, the optical microscope, the blackness measurement method, and the X-ray spectroscopy attached to the scanning electron microscope.

5. The quality control system for the secondary battery according to claim 4,
wherein the structure information includes at least one item of
information on the number and area ratio of defects between the active materials per unit area and information on a total sum of the number or lengths of cracks in the active materials per unit area, each of which is based on a secondary electron image of the portion of the electrode mixture sheet fixed to the inspection holder in the scanning electron microscope, and
information on the aggregate size obtained by quantifying sizes of regions having different contrasts reflecting atomic weights of constituent elements and an area ratio therebetween, the ratio between the constituent materials in the in-plane or thickness direction, and the void ratio, which are based on a back scattered electron image in the scanning electron microscope.

6. The quality control system for the secondary battery according to claim 1,
wherein the performance prediction model is obtained by producing the electrode mixture sheet having a different structure by controlling manufacturing conditions and formulating, by regression analysis, the correlation between the structure information obtained from the electrode mixture sheet and the performance information of a battery produced from the electrode mixture sheet.

7. The quality control system for the secondary battery according to claim 6,
wherein the performance prediction model is constructed by repeating regression analysis of a relationship between the structure information obtained from the electrode mixture sheet for which only a specific one of the manufacturing conditions has been changed and the performance information of the battery produced from the electrode mixture sheet until a correlation coefficient of a correlation function obtained by the regression analysis becomes equal to or less than a predetermined value.

8. The quality control system for the secondary battery according to claim 1, further comprising:
a control unit,
wherein the control unit causes the storage unit to store manufacturing information, which is used for the manufacturing of the electrode mixture sheet to be applied to at least one of the positive electrode and the negative electrode of the secondary battery, and includes at least one of material specifications, a material manufacturing lot, mixing conditions, coating conditions, and pressing conditions each for forming the electrode mixture sheet, and, when battery performance predicted in the performance prediction unit does not satisfy a criterion determined in advance, the control unit determines that any item of the manufacturing information is not appropriate, and controls the storage unit to update the manufacturing information stored therein.

9. The quality control system for the secondary battery according to claim 1,
wherein information to be stored in the storage unit includes degradation information, which indicates a variation of battery performance caused by the use of a battery incorporated as a storage battery system after shipping, and includes at least one of a capacity retention rate, a resistance increase rate, a speed at which an active material utilization rate in each of the positive electrode and the negative electrode decreases, and a speed at which an ionic conduction resistance inside the battery increases.

10. The quality control system for the secondary battery according to claim 9, further comprising:
a degradation prediction model production unit that produces a degradation prediction model by formulating, by regression analysis, the correlation between the structure information obtained from the electrode mixture sheet having a different structure that has been manufactured by controlling manufacturing conditions and the degradation information of the battery produced from the electrode mixture sheet; and
a degradation prediction unit that inputs the structure information of the newly manufactured electrode mixture sheet to the degradation prediction model to predict degraded performance of the battery manufactured by applying the electrode mixture sheet during operation thereof,
wherein the degradation information indicates the variation of the battery performance caused by the use of the battery incorporated as the storage battery system after the shipping, and includes at least one of the capacity retention rate, the resistance increase rate, the speed at which the active material utilization rate in each of the positive electrode and the negative electrode decreases, and the speed at which the ionic conduction resistance inside the battery increases.

11. The quality control system for the secondary battery according to claim 10,
wherein the degradation prediction model production unit repeats regression analysis of a relationship between the structure information obtained from the electrode mixture sheet for which only a specific one of the manufacturing conditions has been changed and the degradation information of the battery produced from the electrode mixture sheet until a correlation coefficient of a correlation function obtained by the regression analysis becomes equal to or less than a predetermined value, to construct the degradation prediction model.

12. The quality control system for the secondary battery according to claim 1,
wherein the secondary battery is any one of a lithium ion secondary battery, a sodium ion secondary battery, a potassium ion secondary battery, and a secondary battery using a multivalent cation as a carrier.

13. The quality control system for the secondary battery according to claim 1,
wherein a solid electrolyte is contained in the electrode mixture sheet used for the secondary battery.

14. A quality control method for a secondary battery comprising:
a performance prediction model production step of producing a performance prediction model by formulating correlation between structure information of an electrode mixture sheet and performance information of the secondary battery manufactured by applying the electrode mixture sheet; and
a performance prediction step of inputting the structure information of the newly manufactured electrode mixture sheet to the performance prediction model to predict battery performance of a battery manufactured by applying the electrode mixture sheet,
wherein the structure information is information related to a structure of the electrode mixture sheet that has been measured after the manufacturing of the electrode mixture sheet to be applied to at least one of a positive electrode and a negative electrode of the secondary battery, and includes at least one of the presence or absence of a defect or break in at least one of the positive electrode and negative electrode, a ratio between constituent materials in an in-plane direction or a thickness direction of the electrode mixture sheet, a size of an aggregate made of the constituent materials, a crack occurring inside an electrode active material particle, and a ratio of voids in which the constituent materials are not present, and
wherein the performance information is information related to performance of the secondary battery manufactured by using the electrode mixture sheet, and includes at least one of capacities during initial charging and discharging, a charge-discharge efficiency as a capacity ratio during charging and discharging, a battery capacity when a charging or discharging current is varied, and an AC resistance and a DC resistance at a predetermined charging rate.

15. The quality control method for the secondary battery according to claim 14,
wherein the performance prediction model is obtained by producing the electrode mixture sheet having a different structure by controlling manufacturing conditions, and formulating the correlation between the structure information obtained from the electrode mixture sheet and the performance information of a battery produced from the electrode mixture sheet by regression analysis.

16. The quality control method for the secondary battery according to claim 15,
wherein the performance prediction model is constructed by repeating regression analysis of a relationship between the structure information obtained from the electrode mixture sheet for which only a specific one of the manufacturing conditions has been changed and the performance information of the battery produced from the electrode mixture sheet until a correlation coefficient of a correlation function obtained by the regression analysis becomes equal to or less than a predetermined value.

17. The quality control method for the secondary battery according to claim 14, further comprising:
a manufacturing information storage step of storing manufacturing information, which is used for the manufacturing of the electrode mixture sheet to be applied to at least one of the positive electrode and the negative electrode of the secondary battery, and includes at least one of material specifications, a material manufacturing lot, mixing conditions, coating conditions, and pressing conditions each for forming the electrode mixture sheet; and
a manufacturing information update step of, when battery performance predicted in the performance prediction step does not satisfy a criterion determined in advance, determining that any item of the manufacturing information is not appropriate, and updating the manufacturing information.

18. The quality control method for the secondary battery according to claim 14, further comprising:
a degradation prediction model production step of producing a degradation prediction model by formulating, by regression analysis, the correlation between the structure information obtained from the electrode mixture sheet having a different structure that has been manufactured by controlling manufacturing conditions and degradation information of the battery produced from the electrode mixture sheet; and
a degradation prediction step of inputting the structure information of the newly manufactured electrode mixture sheet to the degradation prediction model to predict degraded performance of the battery manufactured by applying the electrode mixture sheet during operation thereof,
wherein the degradation information indicates the variation of the battery performance caused by the use of the battery incorporated as a storage battery system after shipping, and includes at least one of a capacity retention rate, a resistance increase rate, a speed at which an active material utilization rate in each of the positive electrode and the negative electrode decreases, and a speed at which an ionic conduction resistance inside the battery increases.

19. The quality control method for the secondary battery according to claim 18,
wherein the degradation prediction model is constructed by repeating regression analysis of a relationship between the structure information obtained from the electrode mixture sheet for which only a specific one of the manufacturing conditions has been changed and the degradation information of the battery produced from the electrode mixture sheet until a correlation coefficient of a correlation function obtained by the regression analysis becomes equal to or less than a predetermined value.

20. The quality control method for the secondary battery according to claim 14,
wherein the electrode mixture sheet is formed by slurrying a mixture of the constituent materials with a liquid, applying the slurry, drying the slurry, and then applying a pressure thereto.

21. The quality control method for the secondary battery according to claim 14,
wherein the electrode mixture sheet is formed by dispersing the mixture of the constituent materials in a solid state into a sheet shape, and applying a pressure thereto.
